# EUROPEAN PATENT SPECIFICATION

(11) **EP 0 766 140 B1**
(45) Date of publication and mention of the grant of the patent: **11.04.2001**
(21) Application number: 96115583.5
(22) Date of filing: 27.09.1996
(51) Int. Cl.: G03F 7/023

(54) **Positive presensitized lithographic printing plate and a process for producing the same**
Positiv arbeitende vorsensibilisierte lithographische Druckplatte und Verfahren zu deren Herstellung
Plaque d'impression lithographique, présensibilisée, de type positif et son procédé de fabrication

(30) Priority: 27.09.1995 JP 27365095
(43) Date of publication of application: 02.04.1997
(73) Proprietor: FUJI PHOTO FILM CO., LTD., Kanagawa-ken (JP)
(72) Inventor: Kawauchi, Ikuo, c/o Fuji Photo Film Co., Ltd., Yoshida-cho, Haibara-gun, Shizuoka (JP); Mizutani, Kazutaka, c/o Fuji Photo Film Co., Ltd., Yoshida-cho, Haibara-gun, Shizuoka (JP); Fukino, Kiyotaka, c/o Fuji Photo Film Co., Ltd., Yoshida-cho, Haibara-gun, Shizuoka (JP); Kitada, Kazuyuki, c/o Fuji Photo Film Co., Ltd., Yoshida-cho, Haibara-gun, Shizuoka (JP); Oda, Kazutaka, c/o Fuji Photo Film Co., Ltd., Yoshida-cho, Haibara-gun, Shizuoka (JP)
(74) Representative: Grünecker, Kinkeldey, Stockmair & Schwanhäusser Anwaltssozietät

(56) References cited:
- EP-A- 0 636 940
- DE-A- 3 738 669
- DE-A- 3 742 387

## Description

The present invention relates to a positive presensitized lithographic printing plate and a process for producing the same. More particularly, the invention relates to a positive presensitized lithographic printing plate having a light-sensitive layer containing both a high molecular weight compound that is insoluble in water but soluble in an alkaline aqueous solution and an alkali-soluble novolac resin, and a process for producing the plate.

Conventional positive presensitized lithographic printing plates have employed novolac phenol-cresol resins as binders. Due to the nature of the novolac resins, the light-sensitive coating is brittle and has poor wear resistance. Hence, such lithographic printing plates have not had a satisfactory press life. Further, such plates are so poor in chemical resistance that their press life is very short under printing conditions that involve frequent use of a plate cleaner or where UV inks are employed.

In order to solve these problems, addition of various high molecular weight compounds as binders has been reviewed. Typical examples of the so far proposed high molecular weight compounds are those which are described in JP-B-52-28401, JP-A-1-291244 and JP-A-2-866 (the term "JP-B" as used herein means an "examined Japanese patent publication" and the term "JP-A" as used herein means an "unexamined published Japanese patent application").

However, these binders interact insufficiently with positive-acting light-sensitive compounds that have only a small tolerance for variations in the time and temperature for development or in the concentration of developing solutions (such tolerance is commonly referred to as "development latitude"). Therefore, the improvement in press life and chemical resistance that is achieved by addition of these binders is compromised by decreased development latitude.

One object of the present invention is to provide a positive presensitized lithographic printing plate having not only a long press life but also a great development latitude.

Another object of the invention is to provide a process for producing the lithographic printing plate.

In particular, the present invention provides a positive presensitized lithographic printing plate which not only has a long press life even under printing conditions involving frequent use of a plate cleaner or where UV inks are employed, but also ensures a great development latitude, and a process for producing such an improved lithographic printing plate.

In order to attain these objects, the present inventors conducted intensive studies, which have eventually led to the accomplishment of the present invention.

Thus, the present invention has the following three embodiments:
(1) A positive presensitized lithographic printing plate comprising a support and a light-sensitive layer formed thereon, said light-sensitive layer containing
   (a-I) an acrylic high molecular weight compound which is insoluble in water but soluble in an alkaline aqueous solution, and is a copolymer having structural units derived from at least one of monomers (1) to (4):
      (1) acrylamides, methacrylamides, acrylate esters and methacrylate esters, each having aromatic hydroxyl groups, and hydroxystyrenes, such as N-(4-hydroxyphenyl) acrylamide, N-(4-hydroxyphenyl)methacrylamide, o-, m- and p-hydroxyphenyl acrylates or methacrylates, and o-, m- and p-hydroxystyrenes;
      (2) unsaturated carboxylic acids such as acrylic acid, methacrylic acid, maleic anhydride and itaconic acid;
      (3) low molecular weight compounds each having, in one molecule, at least one unsaturated bond polymerizable with a sulfonamido group having at least one hydrogen atom bonded to nitrogen atom, such as compounds of the following formulae (I) to (V): 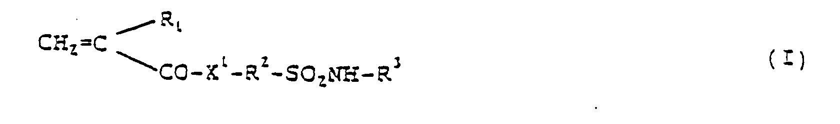 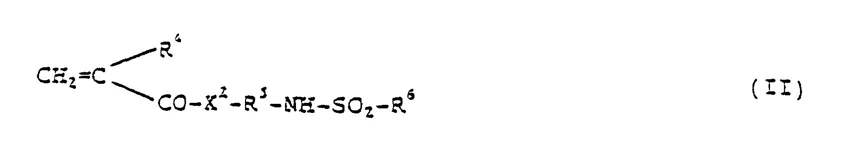 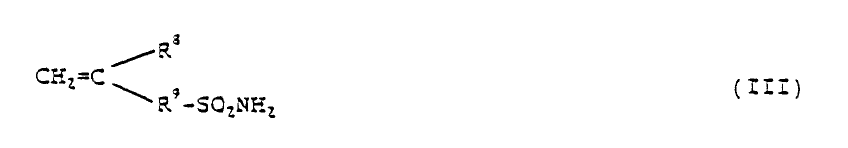 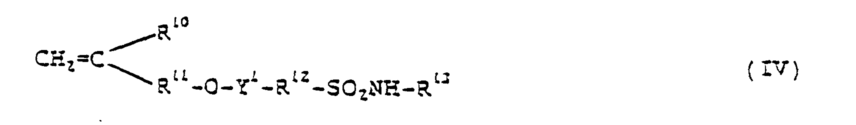 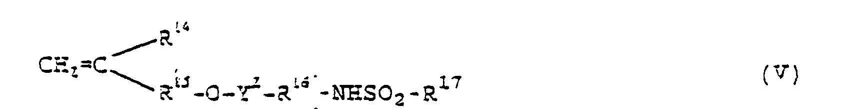 wherein X¹ and X² each represent -O- or NR⁷-; R¹ and R⁴ each represent a hydrogen atom or -CH₃; R², R⁵, R⁹, R¹² and R¹⁶ each represent an optionally substituted alkylene having 1 to 12 carbon atoms, cycloalkylene, arylene or aralkylene group; R³, R⁷ and R¹³ each represent a hydrogen atom or an optionally substituted alkyl having 1 to 12 carbon atoms, cyloalkyl, aryl or aralkyl group; R⁶ and R¹⁷ each represent an optionally substituted alkyl having 1 to 12 carbon atoms, cycloalkyl, aryl or aralkyl group; R³, R¹⁰ and R¹⁴ each represent a hydrogen atom, a halogen atom or -CH₃; R¹¹ and R¹⁵ each represent a single bond or an optionally substituted alkylene having 1 to 12 carbon atoms, cycloalkylene, arylene or aralkylene group; and Y¹ and Y² each represent a single bond or -CO-, with specific examples of these compounds including m-aminosulfonylphenyl methacrylate, N-(p-aminosulfonylphenyl)methacrylamide and N-(p-aminosulfonylphenyl)acrylamide;
      (4) low molecular weight compounds each having, in one molecule, at least one unsaturated bond polymerizable with an active imino group, as represented by the following formula (VI) : 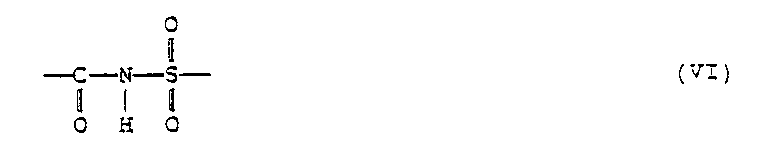 with examples of these compounds including N-(p-toluenesulfonyl)methacrylimide and N-(p-toluenesulfonyl)acrylimide,
      and/or
   (a-II) an urethane-based high molecular weight compound which is insoluble in water but soluble in an alkaline aqueous solution,
   (b) an alkali-soluble novolak resin,
      and
   (c) a positive-acting light-sensitive compound;
   either said high molecular weight compound or said resin
   providing dispersed island phases in a sea phase, the islands
   having spherical or ellipsoidal shape with a maximum major axis particle diameter of 0.1 to 0.8 µm and an average major axis
   particle diameter of 0.05 to 0.6 µm.
(2) A process for producing the positive presensitized lithographic printing plate of (1) comprising roughening a surface of a continuously traveling support, continuously applying a light-sensitive solution onto the support and spraying high-pressure air to the as-applied and undried coating from a slit nozzle installed substantially perpendicular to the direction of travel, thereby drying the film continuously.
(3) A process for producing the positive presensitized lithographic printing plate of (1) comprising roughening a surface of a continuously traveling support, continuously applying a light-sensitive solution onto the support and spraying high-pressure air to the as-applied and undried coating from a slit nozzle installed substantially perpendicular to the direction of travel while heating an underside of the support with a heating roller, thereby drying the film continuously.

Fig. 1 is a SEM micrograph showing a sea-island structure in the light-sensitive layer of the positive presensitized lithographic printing plate of the present invention; and
Fig. 2 is a schematic structural view showing one example of the continuous coating and drying apparatus which can be used to produce the printing plate of the present invention.

Specific embodiments of the present invention will now be described in detail below.

The positive presensitized lithographic printing plate of the present invention has a light-sensitive layer containing the following components:
(a-I) an acrylic high molecular weight compound which is insoluble in water but soluble in an alkaline aqueous solution, and is a copolymer having structural units derived from at least one of the above monomers (1) to (4),
   and/or
(a-II) an urethane-based high molecular weight compound which is insoluble in water but soluble in an alkaline aqueous solution,
(b) an alkali-soluble novolak resin,
   and
(c) a positive-acting Light-sensitive compound.

In the light-sensitive layer containing these compounds, either the high molecular weight compound (a) or the novolac resin (b) provides dispersed phases of a specified size. Such dispersed phases are formed when the high molecular weight compound (a) is immiscible with the novolac resin (b), and they may be true spheres or oblong spheres of (b) that are present in a matrix phase of (a), or alternatively, dispersed phases comprising true spheres or oblong spheres of (a) are present in a matrix phase of (b). For the purpose of the following discussion, a structure having the above-defined dispersed phases is designated a "sea-island structure".

To examine a "sea-island structure" in the present invention, a presensitized lithographic printing plate is sliced with a microtome or other suitable device. The thus obtained section of the light-sensitive layer is rendered electrically conductive and a picture is taken with a scanning electron microscope (SEM), with the size of the circular or elliptical dispersed phases being evaluated with an image analyzer. If the image of the picture is not sharp enough, a suitable method such as a method described in "Polymer Alloys and Polymer Blends (in Japanese)" (L.A. Utracki; Trans. by T. Nishi, Tokyo Kagaku Dojin) may be employed to treat the section of the light-sensitive layer by, for example, etching with a solvent before picture is taken to produce a sharp image.

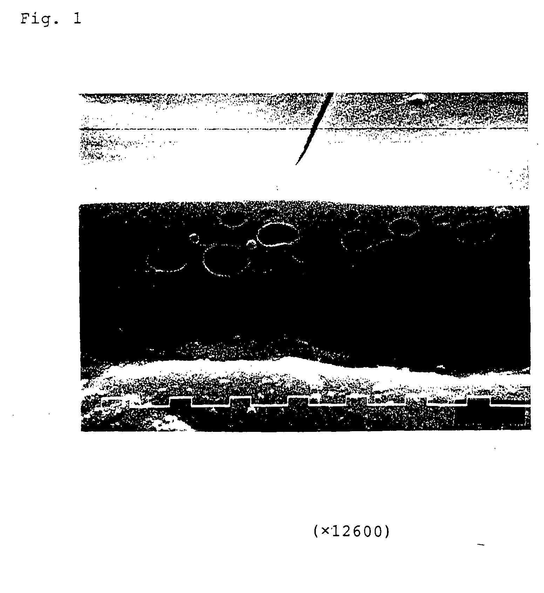

An SEM micrograph of a section of the light-sensitive layer having a sea-island structure is shown in Fig. 1, where the light-sensitive layer provided on a support having an anodized film formed thereon is shown together with the support. It is observed that the light-sensitive layer has dispersed phases of oblong spheres present in a matrix phase.

As will be described hereinafter, the size of dispersed phases present in the matrix phase of the sea-island structure depends on factors such as the coating solvent system used and the conditions of drying after coating. By controlling these conditions, the maximum major axis of the dispersed phases can be adjusted to 0.1 to 0.8 µm, and preferably 0.1 to 0.6 µm, whereas the average major axis is adjusted to 0.05 to 0.6 µm, and preferably 0.05 to 0.5 µm. Both the maximum and average major axes are preferably small. The major axis can be determined on the dispersed particles by performing image analysis in the manner just described above. It means the diameter if the particles are circular in cross section and it means the major axis in the true sense of the term if the particles have an elliptical cross section.

By controlling the size of the dispersed phases to lie within the ranges described above, one can achieve a longer press life and a greater development latitude and, what is more, one can not only assure a long press life even under printing conditions that involve frequent use of a plate cleaner or where UV inks are employed but also provide a great development latitude. Further improvements of press life and development latitude can be achieved by adjusting the size of the dispersed phases to the preferred ranges.

On the other hand, if the maximum major axis of the dispersed phases exceeds 0.8 µm or if their average major axis exceeds 0.6 µm, local insufficiency in wear or chemical resistance (if the major component of the islands is the acrylic or urethane-based high molecular weight compound (a) which is insoluble in water but soluble in an alkaline aqueous solution) or local insufficiency in developability (if the major component of the islands is the alkali-soluble novolac resin (b)) will affect macroscopically to cause problems on the press life and development latitude.

The positive presensitised lithographic printing plate of the present invention is produced by coating a traveling support continuously with a light-sensitive solution containing a light-sensitive composition for forming a light-sensitive sensitive layer, after roughening a surface of the support, and subsequently drying the applied coating in a continuous manner. In order to ensure that the dispersed phases in the sea-island structure of the light-sensitive layer to be formed by the process described above have a maximum major axis of 0.8 µm or less and an average major axis of 0.6 µm or less, the choice of a suitable coating solvent is an important factor. By using an appropriate coating solvent system, the sea-island structure will have the desired size, making it possible to produce a presensitized lithographic printing plate that is satisfactory in both press life and development latitude. Although no definite theory has been postulated to explain the mechanism for reducing the size of dispersed phases by selection of a suitable coating solvent system, the following compounds are preferred for use as coating solvents in the present invention:
Ketones such as cyclohexane and methyl ethyl ketone;
Alcohols such as methanol, ethanol, propanol and 1-methoxy-2-propanol;
Cellosolves such as ethylene glycol monomethyl ether;
Lactones such as γ-butyrolactone;
Sulfoxides such as dimethyl sulfoxide and sulforan;
Halides such as ethylene dichloride;
Acetates such as 2-methoxyethyl acetate and 1-methoxy-2-propyl acetate;
Ethers such as dimethoxyethane;
Esters such as methyl lactate and ethyl lactate;
Amides such as' N,N-dimethoxyacetamide and N,N-dimethylformamide;
Pyrrolidones such as N-methylpyrrolidone;
Ureas such as tetramethylurea; and
Aromatics such as toluene.

Among these compounds, methyl ethyl ketone, 1-methoxy-2-propanol, ethylene glycol monomethyl ether, γ-butyrolactone and dimethyl sulfoxide are particularly preferred.

The solvents listed above may be used either alone or as mixture thereof.

In addition to the choice of a suitable coating solvent system, the conditions of drying the undried coating which has been just formed by application of the light-sensitive solution are also an important factor in ensuring that the dispersed phases in the sea-island structure of the light-sensitive layer will have the specified size. In the present invention, the choice of a suitable coating solvent system ensures that the dispersed phases in the sea-island structure of the light-sensitive layer have the specified size even if drying is performed under ordinary conditions. However, if the undried coating is dried rapidly such that the sea-island structure forming in the drying process is controlled to form within a shorter time, the growth of the sea-island structure is retarded, allowing for more positive control in the maximum major axis of the dispersed phases. As described hereinafter, rapid drying of the undried coating can effectively be accomplished by blowing high-pressure air against the as-applied coating in the drying process from slit nozzle provided substantially perpendicular to the direction of web travel. In this manner, the maximum major axis of the dispersed phases in the sea-island structure of the light-sensitive layer can be controlled to 0.8 µm or less and their average major axis to 0.6 µm or less, thereby producing a lithographic printing plate that is satisfactory in both press life and development latitude and which not only has a long press life even under printing conditions that involve frequent use of a plate cleaner or where UV inks are employed but also ensure a great development latitude.

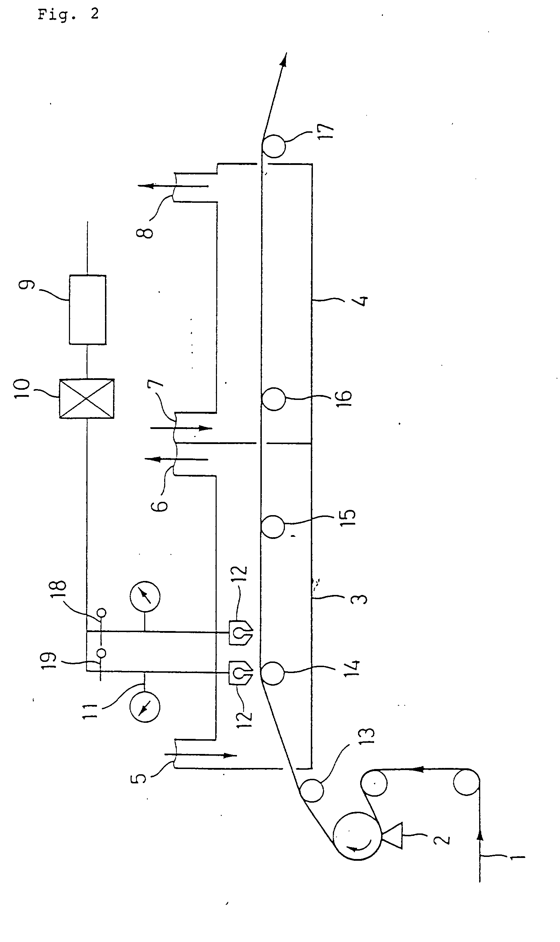

An example of the apparatus for performing continuous coating and drying on a roughened aluminum web used as a support is shown in Fig. 2.

The apparatus shown in Fig. 2 comprises an application head 2 which coats the roughened aluminum web 1 with a light-sensitive solution, a first drying zone 3 which performs high-speed drying by the combination of hot air and blown high-pressure air, and a second drying zone 4 which performs drying with hot air. The first drying zone 3 has a hot air supply port 5, a generator 9 of high-pressure air for achieving high-speed drying, a heat exchanger 10, a pressure gage 11, high-pressure air blow-off nozzles 12, air flow regulating dampers 18 and 19, and an exhaust port 6 for discharging hot air out of the system. The second drying zone 4 also has a hot air supply port 7 and an exhaust port 8 for discharging hot air out of the system. The apparatus shown in Fig. 2 is also furnished with a plurality of guide rolls 13 to 17 that are installed in appropriate positions for transporting the aluminum web 1.

The roughened aluminum web 1 traveling continuously at 5 to 150 m/min in the apparatus is coated with a light-sensitive solution in an amount of 5 to 40 ml/m² by means of the application head 2 and guided into the first drying zone 3, where the web 1 is progressively dried with hot air usually at a temperature of 50 to 150°C that is fed through the supply port 5. The evaporating solvent gas accompanies the hot air and is discharged out of the system through the exhaust port 6. The coating on the web 1 is usually in an undried state just after it has been subjected to the drying action of hot air within and near the entrance of the first drying zone 3.

High-speed blow-off nozzles 12 are installed substantially perpendicular to the travel direction of web 1 at transport positions of the undried coating and high-speed air blown out through the nozzles will allow the coating to dry very rapidly.

The high-speed blow-off nozzles 12 are connected to the high-pressure air generator 9 in the form of a compressor or a high-pressure blower such that the high-pressure air generated is heated to 50 to 200°C in the heat exchanger 10, and then adjusted to a desired flow rate by means of the airflow regulating dampers 18 and 19 before it is supplied to the nozzles. In this manner, the slit high-pressure air having the desired temperature and velocity is allowed to impinge violently against the undried coating, whereby the solvent is evaporated within a very short time to form a light-sensitive film (or layer). The high-pressure air has a pressure of 0.03 kg/cm² (300 mmAq (H₂O)) to 3 kg/cm², preferably 0.1 kg/cm² (1,000 mmAq) to 1 kg/cm², within each nozzle 12. Air is ejected through the blow-off nozzles 12 at a velocity of 20 m/s to 300 m/s. The slit gap in each nozzle 12 is generally 0.1 mm to 5 mm, and preferably 0.3 mm to 1 mm. The high-pressure air may be blown against the aluminum web 1 at an angle of 0° to 90°, and preferably 10° to 60°. Two blow-off nozzles 12 are used in the apparatus shown in Fig. 2 but depending on the drying load, the nozzle number may be reduced to one or increased up to eight.

In a preferred embodiment of the present invention, drying with high-speed air is combined with drying with a heating roll, which may be the guide roll 14. In this case, a heating medium such as steam may be supplied into the roll such that its surface temperature is raised to 80 to 200°C. The heat of the roll as applied to the underside of the aluminum web 1 gives a sufficient amount of thermal energy to permit more rapid removal of the solvent than when the high-pressure air is solely supplied through the blow-off nozzles. As a result, the size of dispersed phases in the sea-island structure can be further reduced.

Thus, high-speed drying is accomplished in the first drying zone 3 to form a dry film, and at the same time, its internal structure is determined. The web 1 is then guided into the second drying zone 4, where it is dried with hot air at 100°C to 150°C that is fed through the supply port 7. As a result, the amount of the residual solvent in the film is controlled to be within the range of 30 to 200 mg/m². The solvent gas is discharged out of the system through the exhaust port 8.

These steps of the drying process can provide the desired structure and quality for the film.

In the embodiment shown in Fig. 2, the drying with hot air in the first drying zone 3 is followed by drying with high-pressure air. However, if desired, the initial drying with hot air may be omitted and the as-applied coating may be immediately subjected to drying with high-pressure air.

For assuring efficiency in the present invention, a coating and drying apparatus of the type shown in Fig. 2 is preferably used to perform continuous coating and drying operations. If possible, the support may be roughened with a roughening means positioned upstream of the application head 2 such that the continuously traveling support can be roughened continuously. This is preferred for the purpose of achieving a higher production rate.

It should be noted here that if a fluorine-based surfactant is added as described hereinafter, a layer having a structure other than the sea-island structure may occasionally be formed on the surface of the light-sensitive layer, but this is not a problem at all if such a structure accounts for 20 wt% or less of all the light-sensitive composition in the light-sensitive layer.

The compounds (a) to (c) used in the present invention are described in detail below.

The acrylic high molecular weight compound (a-I) which is insoluble in water but soluble in an alkaline aqueous solution is a copolymer having structural units derived from at least one of monomers (1) to (4) described below:
(1) Acrylamides, methacrylamides, acrylate esters and methacrylate esters, each having aromatic hydroxyl groups, and hydroxystyrenes, such as N-(4-hydroxyphenyl)acrylamide, N-(4-hydroxyphenyl)methacrylamide, o-, m- and p-hydroxyphenyl acrylates or methacrylates, and o-, m- and p-hydroxystyrenes;
(2) Unsaturated carboxylic acids such as acrylic acid, methacrylic acid, maleic anhydride and itaconic acid;
(3) Low molecular weight compounds each having, in one molecule, at least one unsaturated bond polymerizable with a sulfonamido group having at least one hydrogen atom bonded to nitrogen atom, such as compounds of the following formulae (I) to (V): 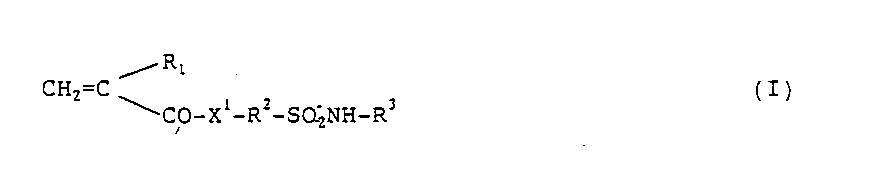 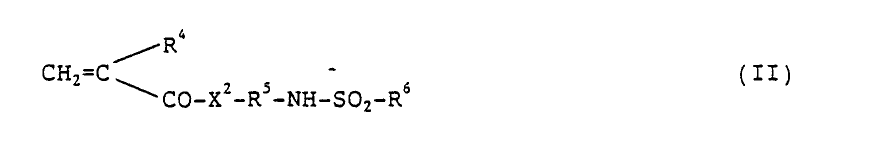 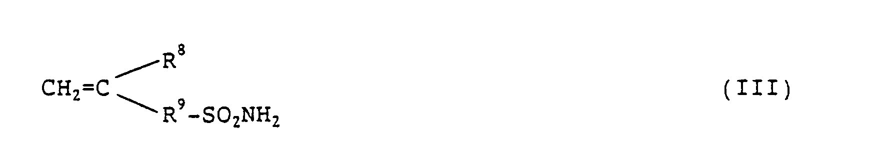 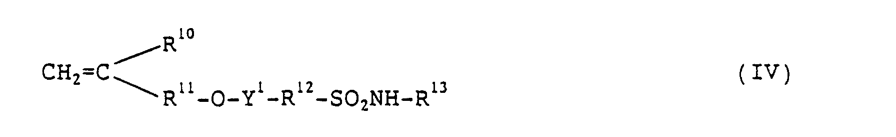 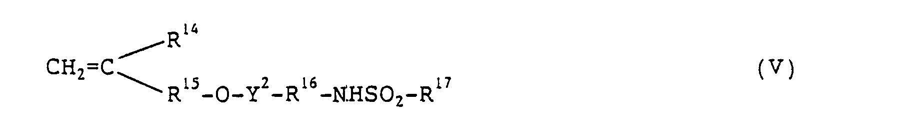 wherein X¹ and X² each represent -O- or NR⁷-; R¹ and R⁴ each represent a hydrogen atom or -CH₃; R², R⁵, R⁹, R¹² and R¹⁶ each represent an optionally substituted alkylene having 1 to 12 carbon atoms, cycloalkylene, arylene or aralkylene group; R³, R⁷ and R¹³ each represent a hydrogen atom or an optionally substituted alkyl having 1 to 12 carbon atoms, cyloalkyl, aryl or aralkyl group; R⁶ and R¹⁷ each represent an optionally substituted alkyl having 1 to 12 carbon atoms, cycloalkyl, aryl or aralkyl group; R⁸, R¹⁰ and R¹⁴ each represent a hydrogen atom, a halogen atom or -CH₃; R¹¹ and R¹⁵ each represent a single bond or an optionally substituted alkylene having 1 to 12 carbon atoms, cycloalkylene, arylene or aralkylene group; and Y¹ and Y² each represent a single bond or -CO-, with specific examples of these compounds including m-aminosulfonylphenyl methacrylate, N-(p-aminosulfonylphenyl)methacrylamide and N-(p-aminosulfonylphenyl)acrylamide;
(4) Low molecular weight compounds each having, in one molecule, at least one unsaturated bond polymerizable with an active imino group, as represented by the following formula (VI): 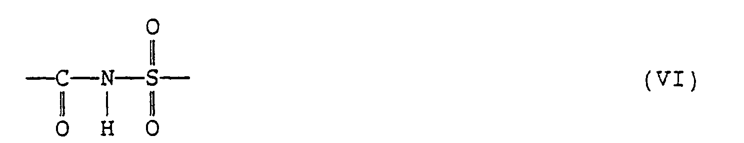 with examples of these compounds including N-(p-toluenesulfonyl)methacrylimide and N-(p-toluenesulfonyl)acrylimide.

Monomers (1) to (4) above are combined with other polymerizable monomers to form copolymers. In this case, the structural units derived from monomers (1) to (4) account for at least 10 mol%, preferably at least 20 mol%, and more preferably at least 25 mol%, of the copolymers. Examples of the monomers which may be used in combination with the monomers (1) to (4) include the following compounds (5) to (15):
(5) Acrylate and methacrylate esters having an aliphatic hydroxyl group, such as 2-hydroxyethyl acrylate and methacrylate;
(6) (Substituted)atkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate and N-dimethylaminoethyl acrylate;
(7) (Substituted)alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, glycidyl methacrylate and N-dimethylaminoethyl methacrylate;
(8) Acrylamides or methacrylamides, such as acrylamide, methacrylamide, N-methylolacrylamide, N-ethylacrylamide, N-hexylmethacrylamide, N-cyclohexyl-N-hydroxyethylacrylamide, N-phenylacrylamide, N-nitrophenylacrylamide and N-ethyl-N-phenylacrylamide;
(9) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether;
(10) Vinyl esters such as vinyl acetate, vinyl chloroacetate, vinyl butyrate and vinyl benzoate;
(11) Styrenes such as styrene, α-methylstyrene, methylstyrene and chloromethylstyrene;
(12) Vinyl ketones such as methyl vinyl ketone, ethyl vinyl ketone, propyl vinyl ketone and phenyl vinyl ketone;
(13) Olefins such as ethylene, propylene, isobutylene, butadiene and isoprene;
(14) N-Vinylpyrrolidone, N-vinylcarbazole, 4-vinylpyridine, acrylonitrile, methacrylonitrile, etc.; and
(15) Unsaturated imides such as maleimide, N-acryloylacrylamide, acryloylacrylamide, N-acetylmethacrylamide, N-propionyl- and N-(p-chlorobenzyl)methacrylamide.

These monomers may be further copolymerized with other copolymerizable monomers. The high molecular weight compounds prepared from the monomers and comonomers described above have preferably a weight average molecular weight of at least 2,000 and a number average molecular weight of at least 1,000. More preferred high molecular weight compounds are those which have a weight average molecular weight of 5,000 to 300,000 and a number average molecular weight of 2,000 to 250,000, with a degree of dispersion (Mw/Mn) being 1.1 to 10.

Examples of the urethane-based high molecular weight compound (a-II) which is insoluble in water but soluble in an alkaline aqueous solution are compounds which are described in JP-A-63-124047, JP-A-63-287946, JP-A-2-866 and JP-A-2-156241. However, the present invention is not limited to those compounds.

In the present invention, the acrylic high molecular weight compound and the urethane-based high molecular weight compound may be used in combination.

Examples of the alkali-soluble novolac resin (b) used in the present invention include phenol-formaldehyde resins, m-cresol-formaldehyde resins, p-cresol-formaldehyde resins, m- and p-mixed cresol-formaldehyde resins, and phenol-cresol (which may m-, p- or m-/p-) mixed formaldehyde resins. These alkali-soluble novolac resins have a weight average molecular weight of 500 to 20,000 and a number average molecular weight of 200 to 100,000. Additionally, condensates between phenols having alkyl groups of C₃ to C₈ as substituents and formaldehyde, such as t-butyl phenol-formaldehyde or octylphenol-formaldehyde resins may be used as disclosed in U.S. Patent 4,123,279.

The positive-acting light-sensitive compound (c) used in the present invention is specifically a o-naphthoquinone azide compound.

Preferred for use as o-naphthoquinone azide compounds in the present invention are esters of 1,2-diazonaphthoquinonesulfonyl chloride with pyrogallol resins as disclosed in JP-B-43-28403. Other preferred orthoquinonediazide compounds are esters of 1,2-diazonaphthoquinonesulfonyl chloride with phenol-formaldehyde resins as disclosed in U.S. Patents 3,046,120 and 3,188,210. Other useful o-naphthoquinone diazide compounds are known and have been reported in many publications and patents, such as JP-A-47-5303, JP-A-48-63802, JP-A-48-63803, JP-A-48-96575, JP-A-49-38701, JP-A-48-13354, JP-A-37-18015, JP-A-41-11222, JP-A-45-9610 and JP-A-49-17481; U.S. Patents 2,797,213, 3,454,400, 3,544,323, 3,573,917, 3,674,495 and 3,785,825; BP 1,227,602, 1,251,345, 1,267,005, 1,329,888 and 1,330,932; and German Patent 854,890.

Particularly preferred o-naphthoquinone diazide compounds are compounds obtained by reacting polyhydroxy compounds having a molecular weight of 1,000 or less with 1,2-diazonaphthoquinonesulfonyl chloride. Specific examples of such compounds are described in JP-A-51-139402, JP-A-58-150948, JP-A-58-203434, JP-A-59-165053, JP-A-60-21445, JP-A-60-134235, JP-A-60-163043, JP-A-61-18744, JP-A-62-10645, JP-A-62-10646, JP-A-62-153950, JP-A-62-178562, JP-A-1-76047 and JP-A-2-213847; and U.S. Patents 3,102,809, 3,126,281, 3,130,047, 3,148,983, 3,184,310, 3,188,210 and 4,636,406.

To synthesize the o-naphthoquinonediazide compounds, polyhydroxy compounds are preferably reacted with 1,2-diazonaphthoquinonesulfonyl chloride in an amount of 0.2 to 1.2 equivalents, more preferably 0.3 to 1.0 equivalent, per hydroxyl group.

The thus prepared o-naphthoquinone diazide compounds are mixtures of compounds having the 1,2-diazonaphthoquinonesulfonate ester group introduced at different positions in different amounts. The proportion of the compounds in which all hydroxyl groups have been converted to the 1,2-diazonaphthoquinonesulfonate ester (i.e., the content of the completely esterified compound) in such mixtures is preferably at least 5 mol%, and more preferably 20 to 99 mol%.

The positive-acting light-sensitive compound (c) may also be prepared without using o-naphthoquinone diazide compounds. One example of this embodiment is using a polymer compound having an orthonitrocarbinol ester group, as described in, for example, JP-B-56-2696.

A compound which generates an acid upon photodegradation may be combined with a compound having a -C-O-C or -C-O-Si group that dissociates with an acid, and this combined system may also be used in the present invention.

For example, a compound which generates an acid upon photodegradation may be combined with an acetal or O,N-acetal compound (as described in JP-A-48-89003), an ortho-ester or amideacetal compound (JP-A-51-120714), a polymer having an acetal or ketal group in the backbone chain (JP-A-53-133429), an enolether compound (JP-A-55-12995), an N-acylimino carbon compound (JP-A-55-126236), a polymer having an ortho-ester group in the backbone chain (JP-A-56-17345), a silyl ester compound (JP-A-60-10247), and a silyl ether compound (JP-A-60-37549 and JP-A-60-121446).

The acrylic and/or urethane-based high molecular weight compound (a) which is insoluble in water but soluble in an alkaline aqueous solution is contained in the light-sensitive composition (for forming the light-sensitive layer) in an amount ranging from 3 to 90 wt%, and preferably from 5 to 85 wt%, of the total light-sensitive composition. The alkali-soluble novolac resin (b) is contained in the light-sensitive composition in an amount ranging from 3 to 90 wt%, and preferably from 5 to 85 wt%, of the total light sensitive composition. The weight ratio of the high molecular weight compound (a) to the novolac resin (b) ranges from 3:97 to 97:3, and preferably from 5:95 to 95:5. The content of the positive-acting light-sensitive compound (c) is from 5 to 50 wt%, and preferably from 10 to 40 wt%, of the total light-sensitive composition.

When these compositional requirements are met, a light-sensitive layer having satisfactory function and a sea-island structure can be produced.

It should, however, be noted that all of the presensitized lithographic printing plates which use the light-sensitive composition satisfying the above-specified compositional requirements do not always have the desirable press life and development latitude. The intended performance will be assured only if the light-sensitive composition satisfies the above-specified compositional requirements and when the light-sensitive layer has a sea-island structure, with the dispersed phases having a maximum major axis of 0.1 to 0.8 µm and an average major axis of 0.05 to 0.6 µm.

While the light-sensitive layer is formed of the light-sensitive composition containing the above-described components (a) to (c), the light-sensitive composition may further contain various additives depending on the need.

For example, cyclic acid anhydrides, phenols and organic acids may be used for providing improved sensitivity. Examples of the cyclic acid anhydrides include the following compounds as described in U.S. Patent 4,115,128: phthalic anhydride, tetrahydrophthalic anhydride, hexahydrophthalic anhydride, 3,6-endoxy-Δ⁴-tetrahydrophthalic anhydride, tetrachlorophthalic anhydride, maleic anhydride, chloromaleic anhydride, α-phenylmaleic anhydride, succinic anhydride and pyromellitic anhydride. Examples of the phenols include bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramythyltriphenylmethane. Examples of the organic acids include the following compounds as described in JP-A-60-88942 and JP-A-2-96755: sulfonic acids, sulfinic acids, alkylsulfuric acids, phophonic acids, phosphate esters and carboxylic acids. Specific examples of the organic acids include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 1,4-cyclohexene-2,2-dicarboxylic acid, erucic acid, lauric acid, n-undecanoic acid and ascorbic acid. The amount of the above-described cyclic acid anhydrides, phenols and organic acids is preferably 0.05 to 15 wt%, and more preferably 0.1 to 5 wt%, of the light-sensitive composition.

In order to expand the scope over which treatment stability is ensured under varying development conditions, the light-sensitive composition for use in the present invention may also contain nonionic surfactants as described in JP-A-62-251742 and JP-A-3-208514, and amphoteric surfactants as described in JP-A-59-121044 and JP-A-4-13149. Specific examples of the nonionic surfactants include sorbitan tristearate, sorbitan monopalmitate, sorbitan trioleate, stearic acid monoglyceride and polyoxyethylene nonylphenyl ether. Specific examples of the amphoteric surfactants include alkyldi(aminoethyl)glycine, alkylpolyaminoethylglycine hydroxides, 2-alkyl-N-carboxyethyl-N-hydroxyethylimidazolium betaine and N-tetradecyl-N,N-betaine compounds (e.g. AMORGEN K, the trade name of Daiichi Kogyo K.K.). The amount of these nonionic and amphoteric surfactants is preferably 0.05 to 15 wt%, and more preferably 0.1 to 5 wt%, of the light-sensitive composition.

The light-sensitive composition for use in the present invention may further contain a printout agent for providing a visible image just after exposure, and dyes or pigments working as image coloring agents. The printout agent is typically combinations of photoactivated acid releasers (i.e., compounds that release acids upon exposure) with organic dyes capable of forming salts. Examples thereof are the combination of o-naphthoquinonediazido-4-sulfonyl halogenides and salt-forming organic dyes as described in JP-A-50-36209 and JP-A-53-8218, and the combination of trihalomethyl compounds and salt-forming organic dyes as described in JP-A-53-36223, JP-A-54-74728, JP-A-60-3626, JP-A-61-143748, JP-A-61-151644 and JP-A-63-58440. Examples of the trihalomethyl compounds are oxazole-based compounds and triazine-based compounds. Those compounds exhibit excellent storage stability to produce distinct printout images.

Image coloring agents may be selected not only from the above-described salt-forming organic dyes but also from other dyes. Including the salt-forming organic dyes, preferred dyes are oil-soluble dyes and basic dyes. Examples of the dyes include Oil Yellow #101, Oil Yellow #103, Oil Pink #312, Oil Green BG, Oil Blue BOS, Oil Blue #603, Oil Black BY, Oil Black BS and Oil Black T-505 (all being products of Orient Chemical Industry Co., Ltd.), Victoria Pure Blue, Crystal Violet (C.I. 42555), Methyl Violet (C.I. 42535), Ethyl Violet, Rhodamine B (C.I. 145170B), Malachite Green (C.I. 42000) and Methylene Blue (C.I. 52015). The dyes described in JP-A-62-293247 are particularly preferred. The dyes described above may be contained in the light-sensitive composition in an amount of 0.01 to 10 wt%, and preferably 0.1 to 3 wt%, of the total solid content in the light-sensitive composition.

For imparting softness or like properties to the coating, plasticizers may optionally be added to the light-sensitive composition for use in the present invention. Examples of the plasticizers which may be used are oligomers and polymers of butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, acrylic acid or methacrylic acid.

The concentration of the above-described components (total solid content containing the additives) in solvents ranges preferably from 1 to 50 wt%. The coating weight (solid content) on the support obtained after coating and drying steps is variable with use. However, speaking of presensitized printing plates, the preferred range is generally from 0.5 to 5.0 g/m². Various coating methods may be employed. Examples thereof include bar coater coating, rotary coating, spray coating, curtain coating, dip coating, air knife coating, blade coating and roll coating. As the coating weight decreases, the apparent sensitivity increases, but the film characteristics of the light-sensitive coating deteriorate.

The light-sensitive layer formed in the present invention may contain fluorine-based surfactants for providing better coating behavior, such as surfactants as described in JP-A-62-170950. Such surfactants are preferably added in an amount of 0.01 to 1 wt%, and more preferably 0.05 to 0.5 wt%, of the total light-sensitive composition.

The support used in the present invention is dimensionally stable films, sheets or plates. Examples of the support include papers, papers optionally laminated with plastics (e.g. polyethylene, polypropylene and polystyrene), metal plates (e.g. aluminum, zinc or copper), plastic films (e.g. cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate and polyvinyl acetal), and papers or plastic films either laminated or deposited with the metals described above. Among these, aluminum plates which has good dimensional stability and which are comparatively inexpensive are particularly preferred. Preferred aluminum plates are either pure aluminum plates or alloy plates, which are mainly composed of aluminum and contain very small amounts of other elements. Plastic films either laminated or deposited with aluminum may also be used. Examples of the other elements which may be contained in aluminum alloys are silicon, iron, manganese, copper, magnesium, chromium, zinc, bismuth, nickel and titanium. The content of the other elements in aluminum alloys is at most 10 wt%. Pure aluminum is particularly preferred in the present invention. However, completely pure aluminum is difficult to produce by the current refining technology. Hence inclusion of slight amounts of the other elements is permissible. Thus, the aluminum plates to be applicable to the present invention are in no way limited in composition, and aluminum plates comprising conventional materials may appropriately be used in the present invention. The aluminum plates used in the present invention have generally a thickness of 0.1 mm to 0.6 mm.

Prior to roughening the aluminum plate, the rolling mill lubricant on the plate surface may be removed by degreasing with, for example, surfactants, organic solvents, alkaline aqueous solutions or the like. While the treatment of roughening the surface of the aluminum plate can be performed by various methods, three typical examples are mechanical roughening, electrochemical dissolving and roughening of the plate surface, and chemical selective dissolution of the plate surface. Mechanical roughening may be accomplished by various known methods such as ball polishing, brushing, blasting and buffing. Electrochemical roughening may be accomplished with an alternating or direct current in an electrolyte of hydrochloric acid or nitric acid. If desired, mechanical and electrochemical roughening methods may be combined as described in JP-A-54-63902. The thus roughened aluminum plate may optionally be subjected to alkali etching and neutralization treatments and, if desired, anodization may be performed in order to enhance the water retention and wear resistance of the plate surface. Various electrolytes which form porous oxide films may be used in the anodization of the aluminum plate. Examples of the electrolyte are sulfuric acid, phosphoric acid, oxalic acid, chromic acid and mixtures thereof. The concentration of these electrolytes is appropriately determined depending on their type.

The process conditions for anodization are variable with the electrolyte used and hence cannot be specified. However, the following conditions will generally suffice: electrolyte concentration, 1 to 80 wt% of solution; electrolyte temperature, 5 to 70°C; current density, 5 to 60 A/dm²; voltage, 1 to 100 V; and electrolysis time, 10 s to 5 min. If the weight of the anodized film is smaller than 1.0 g/m², the resulting lithographic printing plate will not have sufficient press life or the non-image areas of the plate are so sensitive to flaws that "flaw stains", i.e., ink deposition in the flaw areas, will readily occur during printing. After anodization, the aluminum plate surface may optionally be rendered hydrophilic. A method which can be used in the present invention to render the aluminum plate surface hydrophilic is an "alkali metal silicate method" (e.g., using an aqueous solution of sodium silicate) as disclosed in U.S. Patents 2,714,066, 3,181,461, 3,280,734 and 3,902,734. In the alkali metal silicate method, the support may be treated by dipping in or electrolysis with an aqueous solution of sodium silicate. Other methods that can be used are a treatment with potassium hexafluorozirconate as described in JP-B-36-22063, or with polyvinylsulfonic acid as described in U.S. Patents 3,276,868, 4,153,461 and 4,689,272.

The positive presensitized lithographic printing plate of the present invention comprises a support having provided thereon a light-sensitive layer formed of a positive-acting light-sensitive composition. If necessary, an undercoat layer may be provided between the support and the light-sensitive layer and a matting layer may be provided on the layer of the light-sensitive composition. Various organic compounds may be used as components of the undercoat layer. Examples of the organic compounds include carboxymethyl cellulose, dextrin, gum arabic, phosphonic acids having an amino group (such as 2-aminoethylphosphonic acid), optionally substituted organic phosphonic acids (such as phenylphosphonic acid, naphthylphosphonic acid, alkylphosphonic acids, glycerophosphonic acid, methylenediphosphonic acid and ethylenediphosphonic acid), optionally substituted organic phosphoric acids (such as phenylphosphoric acid, naphthylphosphoric acid, alkylphosphoric acids and glycerophosphoric acid), optionally substituted organic phosphinic acids (such as phenylphosphinic acid, naphthylphosphinic acid, alkylphosphinic acids and glycerophosphinic acid), amino acids (such as glycine and β-alanine), and hydrochlorides of amines having a hydroxyl group (such as triethanolamine hydrochloride). These organic compounds may be used either alone or as mixtures thereof.

The organic undercoat layer can be formed of these compounds by the following methods. First, the organic compounds described above are dissolved in water or organic solvents such as methanol, ethanol and methyl ethyl ketone or mixtures thereof, and the resulting solutions are coated on the aluminum plate and dried. Alternatively, the aluminum plate may be dipped in the above solutions such that the dissolved organic compounds are adsorbed on the plate surface, which is subsequently washed with water or the like and dried to form the organic undercoat layer. According to the first method, solutions containing the organic compounds at a concentration of 0.005 to 10 wt% can be coated by various methods. For implementing the second method, the dip solutions have a concentration of 0.01 to 20 wt%, and preferably 0.05 to 5 wt%. Dipping is performed at a temperature of 20 to 90°C, preferably 25 to 50°C, for a period of 0.1 s to 20 min, preferably 2 s to 1 min. The solutions for forming the undercoat layer may have a pH adjusted to a value between 1 and 12 by treatment with basic substances such as ammonia, triethylamine and potassium hydroxide or acidic substances such as hydrochloric acid and phosphoric acid. If desired, yellow dyes may be added in order to assure better tone reproduction on the presensitized lithographic printing plate. The coating weight of the organic undercoat layer is 2 to 200 mg/m², and preferably 5 to 100 mg/m². If the coating weight of the organic undercoat layer is less than 2 mg/m², satisfactory press life is not attained, and if the coating weight of the organic undercoat layer is greater than 200 mg/m², the same result is obtained.

The surface of the light-sensitive layer formed of the positive-acting light-sensitive composition used in the present invention is provided with a matting layer in order to shorten the drawdown time in contact exposure with a vacuum printing frame and to prevent blur in printing. Specifically, the matting layer may be provided as described in JP-A-50-125805, JP-B-57-6572 and JP-B-61-28986, or a solid powder may be thermally fused as described in JP-B-62-62337. The particles in the matting layer for use in the present invention have preferably an average particle size of 100 µm or less, and more preferably 2 to 8 µm. With larger average particle size, fine lines are difficult to deposit and an increased loss of highlight dots occurs, which is undesirable for the purpose of faithful tone reproduction. If the average particle size of the matting layer is smaller than 2 µm, the vacuum frame contact is poor, causing blur in printing. The coating weight of the matting layer is preferably 5 to 200 mg/m², and more preferably 20 to 150 mg/m². If the coating weight of the matting layer is greater than 200 mg/m², undue friction will develop and if the coating weight of the matting layer is smaller than 5 mg/m², poor vacuum frame contact occurs.

The thus prepared positive presensitized lithographic printing plate is usually subjected to imagewise exposure and subsequent processing. Actinic rays for imagewise exposure may be emitted from various light sources such as a mercury lamp, a metal halide lamp, a xenon lamp, a chemical lamp and a carbon arc lamp. Radiations may be used, and the examples thereof include electron beams, X-rays, ion beams and far infrared rays. Further, g-line, i-line, deep UV light and high-density energy beams (i.e., laser beams) may also be used. Sources of the laser beams include a helium-neon laser, an argon laser, a krypton laser, a helium-cadmium laser and a KrF excimer laser.

Conventional aqueous alkali solutions may be used as developing and replenishing solutions for the positive presensitized lithographic printing plate of the present invention. Examples of the alkali include inorganic alkali salts such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, ammonium hydroxide, potassium hydroxide and lithium hydroxide. Organic alkalis may also be used, and examples thereof include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethylenediamine, ethyleneimine and pyridine. These alkali agents may be used either alone or as mixtures of two or more thereof. Among these alkali agents, particularly preferred developers are aqueous solutions of alkali metal silicates such as sodium silicate and potassium silicate. This is because developability can be controlled by adjusting the relative proportions and concentrations of the two components of the silicates, i.e., silicon oxide SiO₂ and alkali metal oxide M₂O. For example, alkali metal silicates as described in JP-A-54-62004 and JP-B-57-7427 may effectively be used.

Development with an automatic processor makes it possible to process a large number of PS plates without changing the developer in a developing tank for an extended period of time if the developer is replenished with an aqueous solution having high alkali intensity. This replenishment method is preferably applied to the present invention. In order to enhance or suppress developability, to disperse the "development scum" and to enhance the ink receptivity of the non-image areas of the printing plate, the developing and replenishing solutions used in the present invention may optionally contain a variety of surfactants and organic solvents. Preferred surfactants include anionic surfactants, cationic sufactants, nonionic surfactants and amphoteric surfactants. In addition, the developing and replenishing solutions used in the present invention may optionally contain reducing agents such as hydroquinone, resorcin, sodium, potassium or other alkali metal salts of inorganic acids (such as sulfurous acid and hydrosulfurous acid), organic carboxylic acids, defoaming agents and water softeners. The printing plate processed with the above-described developing and replenishing solutions are subjected to, post-treatments with washing water, rinsing solutions containing surfactants or the like, and desensitizing solutions containing gum arabic and starch derivatives. These post-treatments may be combined in various ways for the treatment of the printing plate of the present invention.

Automatic processors for printing plates are widely used in modern platemaking and printing shops for the purpose of rationalizing and standardizing platemaking operations. Such automatic processors generally comprise a developing section and a post-treatment section. More specifically, it comprises a plate transport unit, tanks of respective processing solutions, and spray units. Exposed printing plate is transported horizontally through the processing zones such that it is sprayed with the respective processing solutions which have been pumped up through nozzles. In the newest processing method, the printing plate is transported through processing solutions in the tanks by means of submerged guide rolls. In these automatic processing methods, the respective processing solutions are replenished in accordance with the throughput, operating time and other factors of the actual operation. Further applicable method is a one-way method which performs the necessary processing with practically "virgin" processing solutions. The presensitized lithographic printing plate of the present invention is exposed imagewise, developed, washed with water and/or rinsed and/or gummed up. If the thus prepared lithographic printing plate has unnecessary image areas (such as vestiges of edges of an original film), the unnecessary image areas must be removed. To this end, a deletion fluid as described in JP-B-2-13293 may preferably be applied to the unnecessary image areas, left as it is for a specified time and then washed with water. Alternatively, actinic rays may be guided through optical fibers such that they are applied to the unnecessary image areas before development as described in JP-A-59-174842.

The thus prepared lithographic printing plate may be coated with a desensitizing gum if this is desired, and thereafter subjected to the printing process. If a further extension of its press life is required, the plate is subjected to burning treatment. Before burning the lithographic printing plate, the plate is preferably processed with a burning conditioner as described in JP-B-61-2518 and JP-B-55-28062, and JP-A-62-31859 and JP-A-61-159655. This can be done by various methods such as coating the lithographic printing plate with sponge or cotton swab impregnated with the burning conditioner, dipping the plate in a vat filled with the burning conditioner, and coating with an automatic coater. Squeezing after the coating operation or leveling off the coating weight by means of squeeze rollers will provide better results. The burning conditioner is generally applied in an amount of 0.03 to 0.8 g/m² (as dry weight). If necessary, the lithographic printing plate coated with the burning conditioner is dried and then heated to high temperature with a burning processor (e.g. Model BP-1300 available from Fuji Photo Film Co., Ltd.). The heating temperature and time depend on the types of the image-forming components and are preferably in the ranges of 180 to 300°C and 1 to 20 min, respectively. The burned-in lithographic printing plate may be subjected to conventional treatments such as washing with water and gumming, which are appropriately selected according to the need. If the burning conditioner used contains a water-soluble high molecular weight compound or the like, so-called "desensitizing" steps such as gumming may be omitted. The lithographic printing plate prepared by the steps described above is set on an offset printing press and used to print a large number of printed matters.

Inks used for printing are UV inks and oily inks.

The present invention is described more specifically by the following examples.

### Example 1

An aluminum plate (Material 1050) having a thickness of 0.3 mm was degreased by cleaning it with trichloroethylene. A surface of the plate was grained using a nylon brush and an aqueous suspension of pumice (400 mesh) and then thoroughly washed with water. The plate was etched by dipping in a 25% aqueous solution of sodium hydroxide at 45°C for 9 seconds, washed with water, and then dipped in 20% nitric acid for 20 seconds, followed by another washing with water. The amount of the grained plate surface was found to be about 3 g/m². Subsequently, the plate was anodized with direct current in 7% sulfuric acid (electrolyte) at a current density of 15 A/dm² to deposit an aluminum oxide film in a coating weight of 3 g/m². The plate was washed with water and dried. The aluminum plate was then coated with an undercoat solution of the formulation shown below and the applied coating was dried at 80°C for 30 seconds. The dry coating weight was 10 mg/m².

| Undercoat solution | |
|---|---|
| β-Alanine | 0.1 g |
| Phenylphosphonic acid | 0.05 g |
| Methanol | 40 g |
| Pure water | 60 g |

The aluminum plate was further coated with light-sensitive solution A of the formulation shown below and dried at 100°C for 2 min with hot air supplied at a velocity of 2 m/s, thereby producing a sample of positive presensitized lithographic printing plate, which is hereinafter designated Sample No. 1. The dry coating weight was 2.0 g/m².

### Light-sensitive solution A

(a) High molecular weight compound insoluble in water but soluble in alkaline aqueous solution (see Table 1)
(b) Alkali-soluble novolac resin (see Table 1)
(c) Positive-acting light-sensitive compound (see Table 1)

| | |
|---|---|
| p-Octylphenol-formaldehyde novolac | 0.02 g |
| Naphthoquinone-1,2-diazido-4-sulfonic acid chloride | 0.01 g |
| Compound of the formula (VII) set forth below | 0.05 g |
| Tetrahydrophthalic anhydride | 0.05 g |
| 4-(p-N,N-Diethoxycarbonylaminophenyl)-2,6-bis(trichloromethyl)-s-triazine | 0.02 g |
| 4-(p-N-(p-Hydroxybenzoylaminophenyl)-2,6-bis(trichloromethyl)-s-triazine | 0.02 g |
| Dye obtained from Victoria Pure Blue BOH by converting the counter ion to 1-naphthalenesulfonate anion | 0.03 g |
| MEGAFAK F-177 (fluorine-based surfactant of Dainippon Ink & Chemicals, Inc.) | 0.06 g |

Coating solvent (see Table 1)

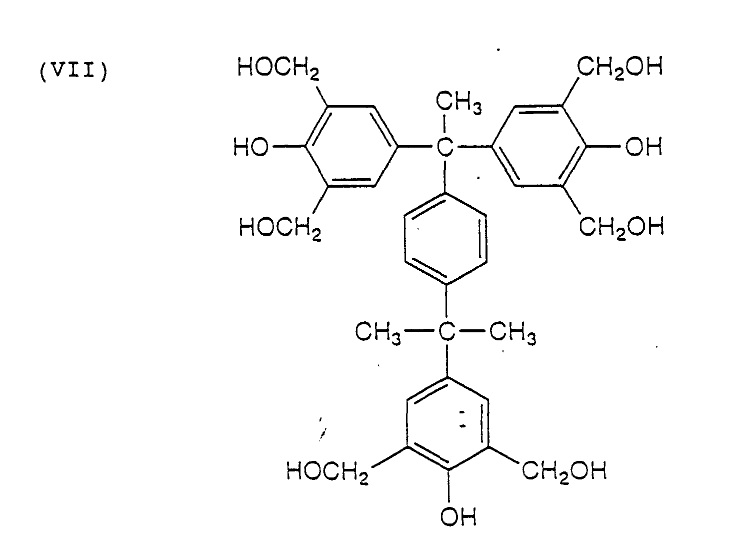

Sample No. 2 was prepared in the same manner as Sample No. 1, except that the light-sensitive layer coating was dried in the drying zones shown in Fig. 2, and after about 10 seconds from the application of the light-sensitive solution A, high-pressure air at 0.3 kg/cm² (3,000 mmAq) was blown against the undried coating through slit nozzles. The overall time of drying in the first drying zone 3 was 15 seconds, the temperature of the hot air used for drying was 80°C and its velocity was 5 m/s, whereas the temperature of the high-pressure air was 60°C and its velocity was 200 m/s. The overall time of drying in the second drying zone 4 was 20 seconds and the temperature of the hot air used for heating was 120°C.

Sample Nos. 3 and 4 were prepared in the same manner as Sample Nos. 1 and 2, respectively, except that light-sensitive solution A was replaced by light-sensitive solution B. The solution B was prepared such that the high molecular weight compound (a), novolac resin (b), light-sensitive compound (c) and the coating solvent in the light-sensitive solution A were replaced by the respective materials shown in Table 1.

Two additional samples were prepared in the same manner as Sample No. 4, except that drying with blown high-pressure air was combined with drying by a heating roll in place of guide roll 14. The drying with the heating roll was performed for 1.2 seconds together with the drying with the blown high-pressure air. The sample prepared with the heating roll held at 100°C (see Table 4) was designated Sample No. 5, and the sample prepared with the heating roll held at 150°C was designated Sample No. 6.

Similarly, Sample Nos. 7 to 16 were prepared using light-sensitive solutions C to G, respectively, with the drying scheme modified as shown in Table 4.

Light-sensitive solutions C to G were prepared such that the high molecular weight compounds (a), novolac resins (b), light-sensitive compounds (c) and the coating solvents in the light-sensitive solution A were replaced with the respective materials shown in Tables 1 to 3.

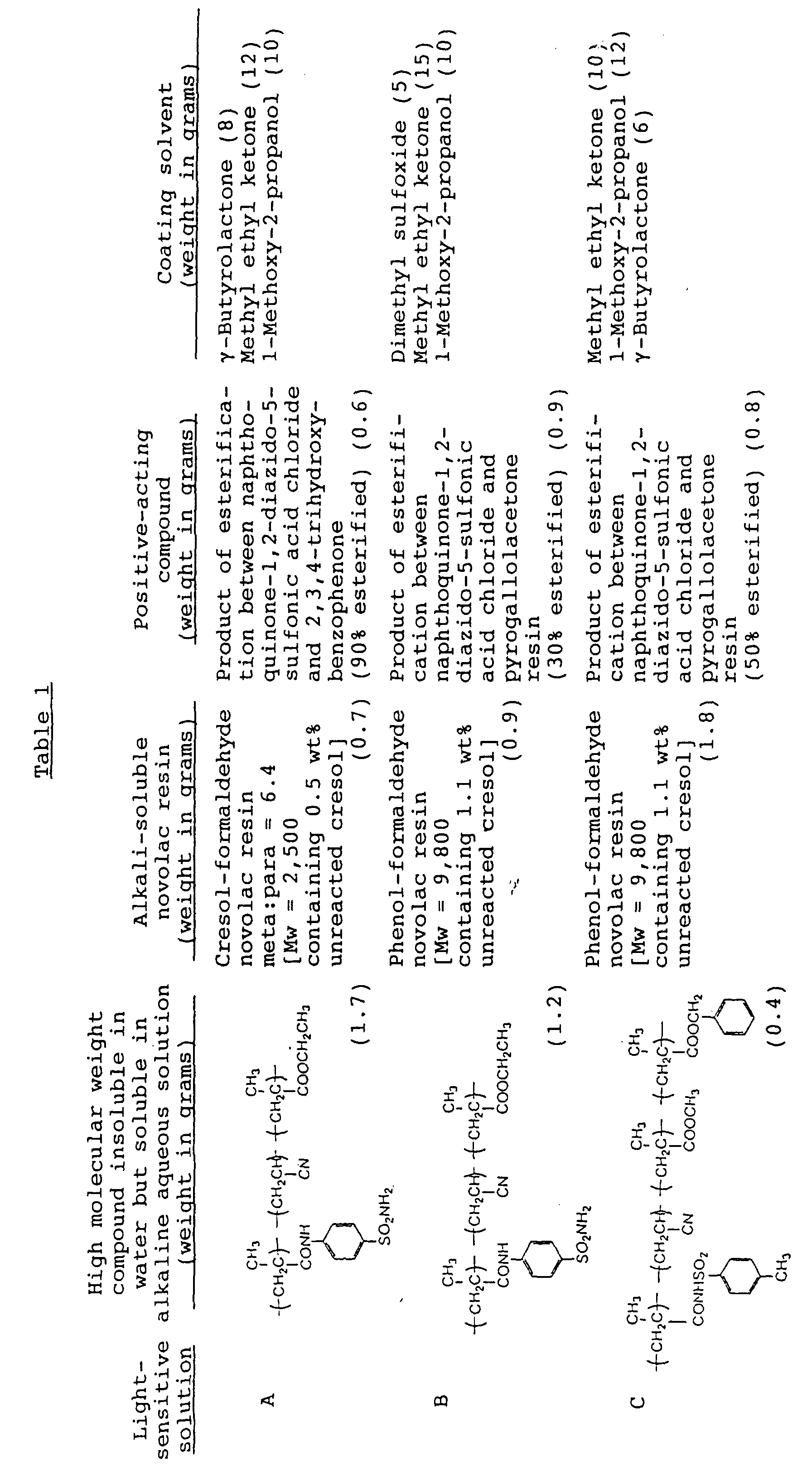

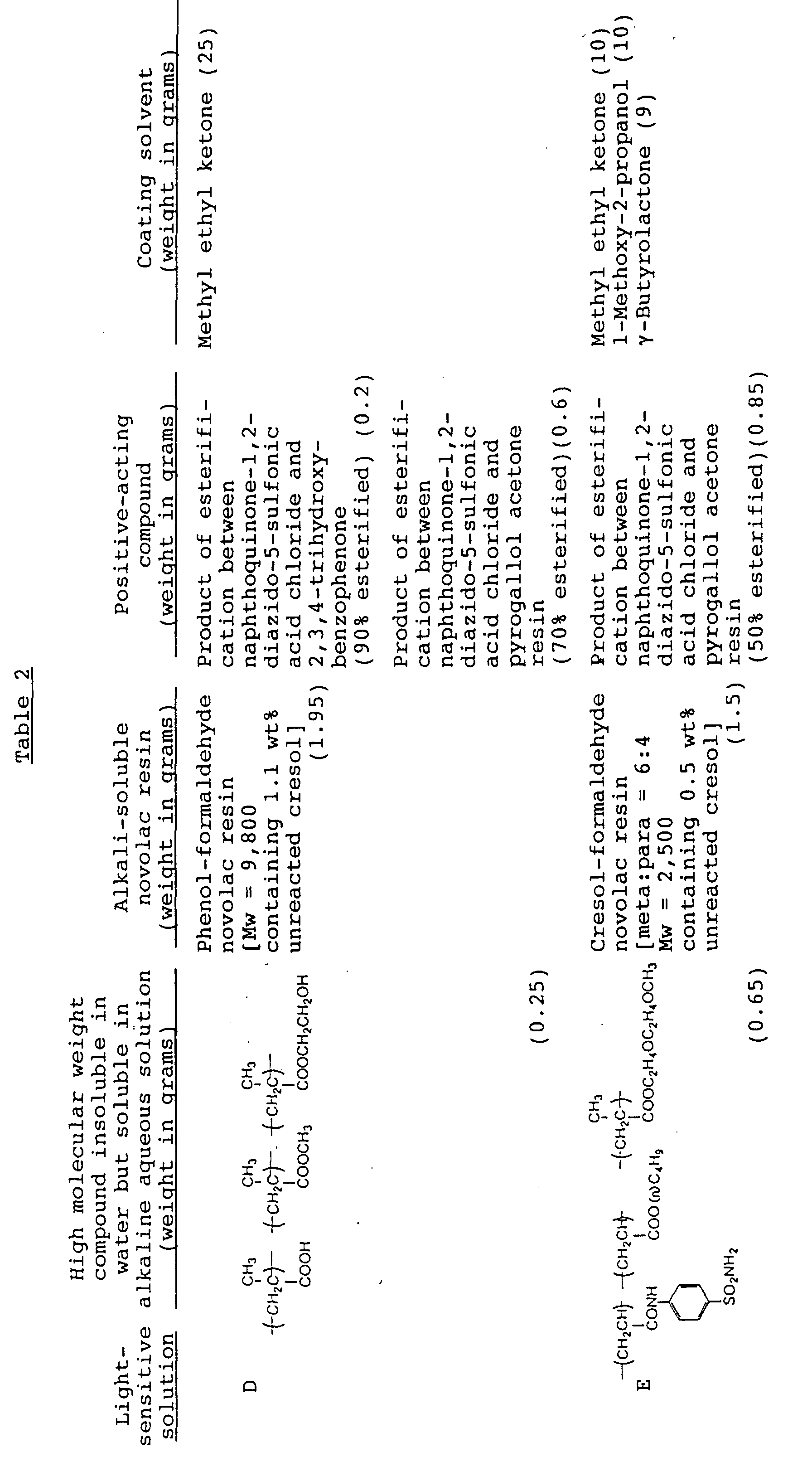

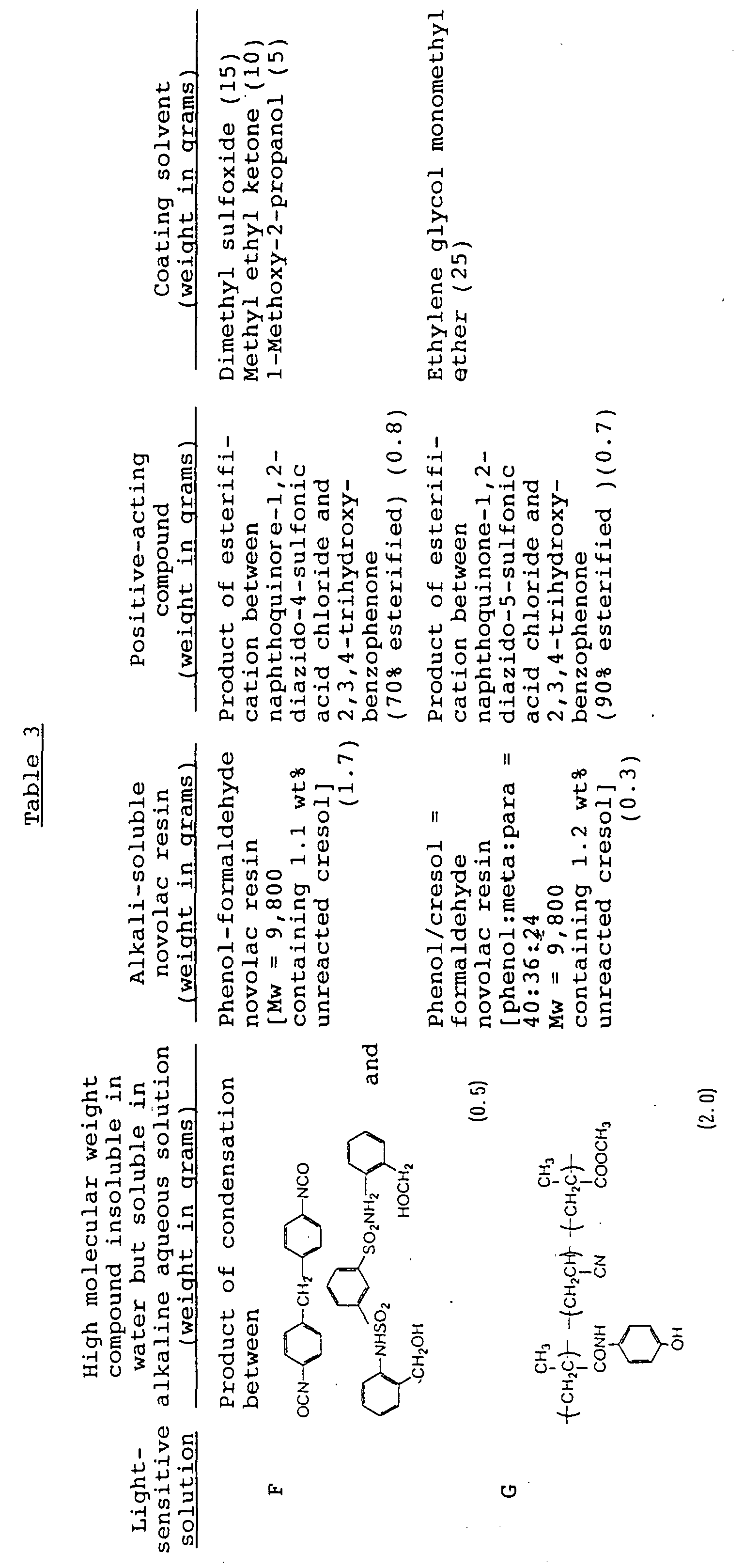

Each of Sample Nos. 1 to 16 for positive presensitized lithographic printing plate was sliced with a microtome in liquid nitrogen and the sliced sections were dipped in methanol for 5 seconds. In order to provide electric conductivity for the surface of each sample, it was coated with a Pt film in a thickness of about 100 Å by ion sputtering. The thus prepared samples were examined with a scanning electron microscope Model S-900 of Hitachi, Ltd. and the SEM images taken (12 kV; without inclination; X30,000) were analyzed with Image Analyzer V10 (general-purpose image analyzer of Toyobo Co., Ltd.) to determine the maximum and average major axes for the dispersed phases in the sea-island structure. The results are shown in Table 4.

The positive presensitized lithographic printing plates were then exposed to a carbon arc lamp (30 A) at a distance of 70 cm and developed automatically with an automatic processor (800U of Fuji Photo Film Co., Ltd.) at 25°C for 40 seconds using an 8-fold dilution of DP-4 (the trade name of Fuji Photo Film Co., Ltd. for a developing solution). The "correct exposure time" was a point of time that 5 steps on a gray scale with a density difference of 0.15 between steps (as produced by Fuji Photo Film Co., Ltd.) became completely clear, and this was an index for the sensitivity of the presensitized lithographic printing plate. In addition, the time required for the occurrence of a change of two steps from the normal was measured, wherein the normal value was the number of solid steps on the gray scale that were obtained by 40-sec vat development with an 8-fold dilution of DP-4 at 25°C. The thus measured time is hereinafter referred to as "development latitude". The thus obtained data on the sensitivity (exposure time) and development latitude of the positive presensitized lithographic printing plates are shown in Table 4.

All samples of the presensitized lithographic printing plate were set in a vacuum printing frame and exposed on a transparent base through a positive original film for 60 seconds using a hydride lamp as a light source. The samples were then processed by passing through an automatic processor charged with DP-4 (1:8) and FR-3 (1:7). DP-4 was a developing solution of Fuji Photo Film Co., Ltd. and FR-3 was a rinsing solution of the same company.

Each of the thus prepared lithographic printing plates was set on a printing press Model KOR-D of Heidelberger Druckmaschinen AG and printing was done with an UV ink (TOKA UV BF of T&K Co., Ltd.). The number of satisfactory printed matters was counted. A similar printing operation was carried out, except that an oily ink was used and the press was shut down after each printing of about 5,000 printed matters, followed by wiping the plate surface with a plate cleaner CL-2 (Fuji Photo Film Co., Ltd.) before printing was restarted. The number of satisfactory printed matters that could be produced by this printing scheme was counted. The results are also shown in Table 4.

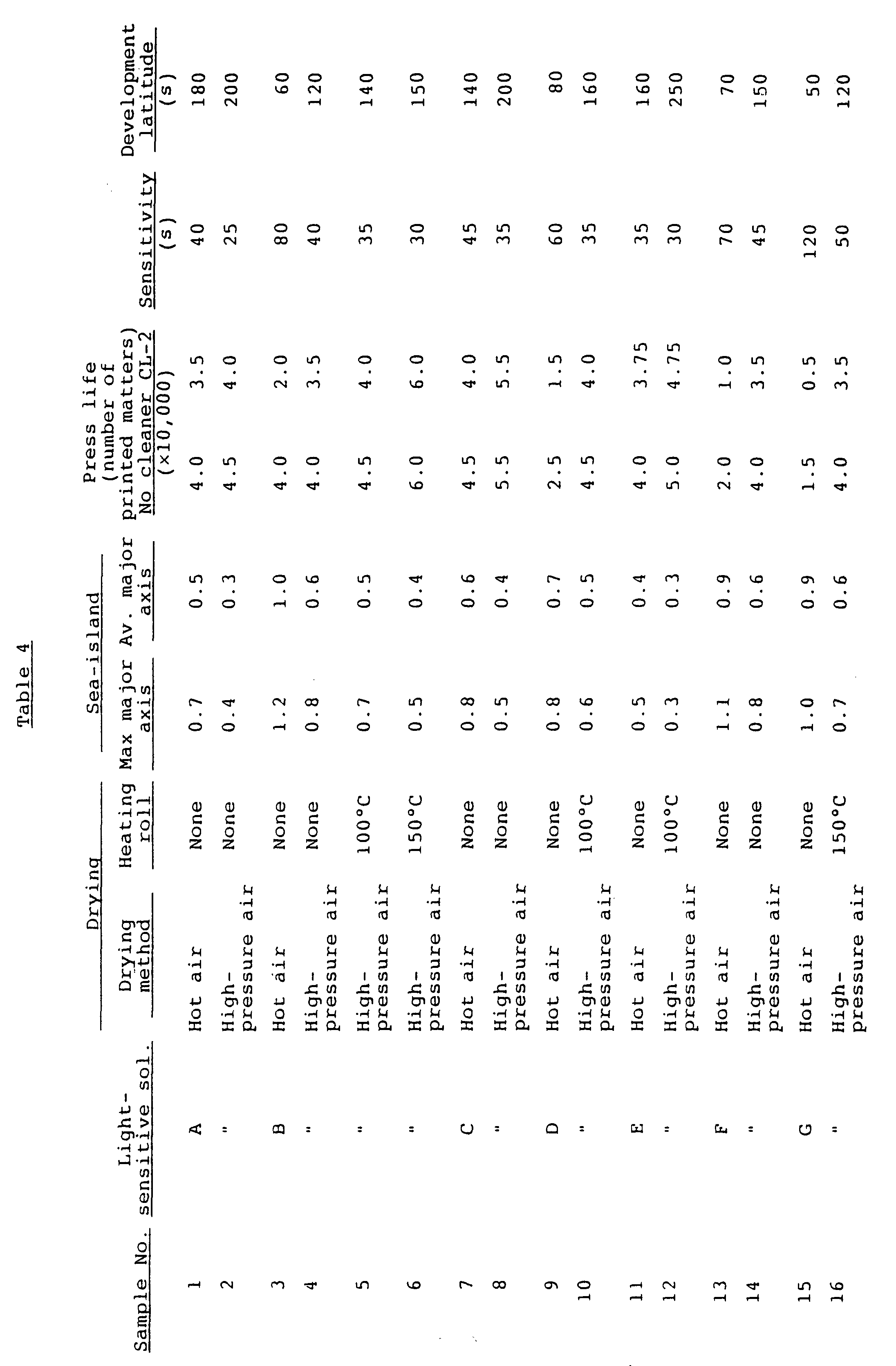

As can be seen from Table 4, Sample Nos. 3, 9, 13 and 15 for lithographic printing plate did not satisfy the requirement that the dispersed phases in the sea-island structure should have a maximum major axis of 0.8 µm or less and an average major axis of 0.6 µm or less, and they either had a very short press life or exhibited very low sensitivity or small development latitude or they were very poor in both characteristics. In addition, the press life of those samples was significantly shortened when the plate cleaner (CL-2) was used. In contrast, the samples according to the present invention which satisfied the above requirements were satisfactory in terms of press life, sensitivity and development latitude and, what is more, their press life was hardly shortened even when the cleaner was used. The improvements in press life, sensitivity and development latitude were marked with decreasing major axis. Sample Nos. 2, 6, 8, 10 and 12 in which the maximum major axis was 0.6 µm or less and the average major axis was 0.5 µm or less exhibited excellent performance.

The positive presensitized lithographic printing plate according to the present invention not only has a long press life even under printing conditions that involve frequent use of a plate cleaner or where UV inks are employed but also ensures a great development latitude.

## Claims

1. A positive presensitized lithographic printing plate comprising a support and a light-sensitive layer formed thereon, said light-sensitive layer containing
(a-I) an acrylic high molecular weight compound which is insoluble in water but soluble in an alkaline aqueous solution, and is a copolymer having structural units derived from at least one of monomers (1) to (4):
(1) acrylamides, methacrylamides, acrylate esters and methacrylate esters, each having aromatic hydroxyl groups, and hydroxystyrenes, such as N-(4-hydroxyphenyl) acrylamide, N-(4-hydroxyphenyl)methacrylamide, o-, m- and p-hydroxyphenyl acrylates or methacrylates, and o-, m- and p-hydroxystyrenes;
(2) unsaturated carboxylic acids such as acrylic acid, methacrylic acid, maleic anhydride and itaconic acid;
(3) low molecular weight compounds each having, in one molecule, at least one unsaturated bond polymerizable with a sulfonamido group having at least one hydrogen atom bonded to nitrogen atom, such as compounds of the following formulae (I) to (V): 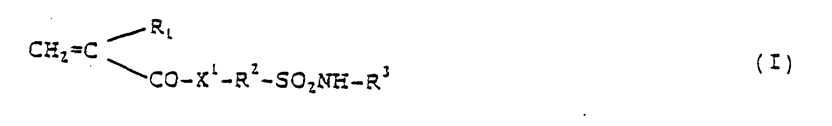 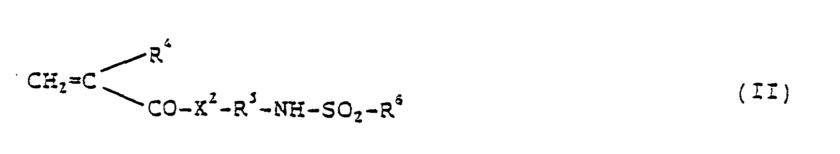 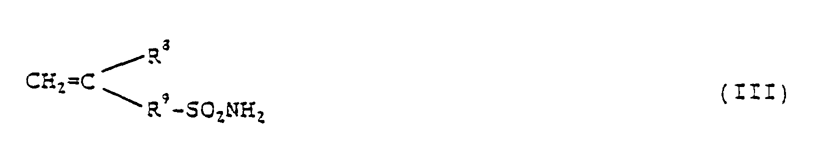 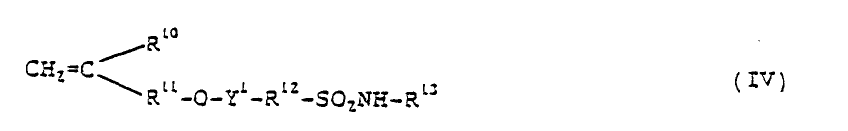 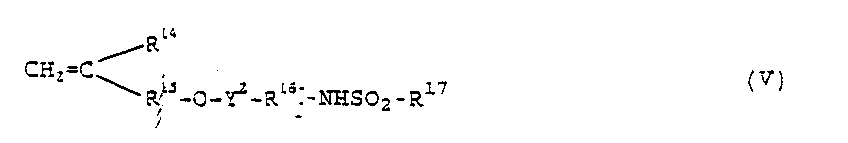 wherein X¹ and X² each represent -O- or NR⁷-; R¹ and R⁴ each represent a hydrogen atom or -CH₃; R², R⁵, R⁹, R¹² and R¹⁶ each represent an optionally substituted alkylene having 1 to 12 carbon atoms, cycloalkylene, arylene or aralkylene group; R¹, R⁷ and R¹³ each represent a hydrogen atom or an optionally substituted alkyl having I to 12 carbon atoms, cyloalkyl, aryl or aralkyL group; R⁶ and R¹⁷ each represent an optionally substituted alkyl having 1 to 12 carbon atoms, cycloalkyl, aryl or aralkyl group; R³, R¹⁰ and R¹⁴ each represent a hydrogen atom, a halogen atom or -CH₃; R¹¹ and R¹⁵ each represent a single bond or an optionally substituted alkylene having 1 to 12 carbon atoms, cycloalkylene, arylene or aralkylene group; and Y¹ and Y² each represent a single bond or -CO-, with specific examples of these compounds including m-aminosulfonylphenyl methacrylate, N-(p-aminosulfonylphenyl)methacrylamide and N-(p-aminosulfonylphenyl)acrylamide;
(4) low molecular weight compounds each having, in one molecule, at least one unsaturated bond polymerizable with an active imino group, as represented by the following formula (VI) : 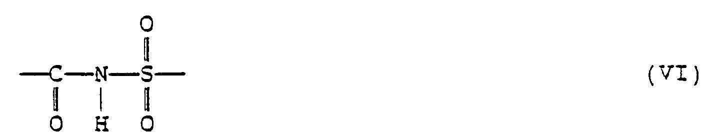 with examples of these compounds including N-(p-toluenesulfonyl)methacrylimide and N-(p-toluenesulfonyl)acrylimide,
and/or
(a-II) an urethane-based high molecular weight compound which is insoluble in water but soluble in an alkaline aqueous solution,
(b) an alkali-soluble novolak resin,
and
(c) a positive-acting light-sensitive compound;
either said high molecular weight compound or said resin
providing dispersed island phases in a sea phase, the islands
having spherical or ellipsoidal shape with a maximum major axis particle diameter of 0.1 to 0.8 µm and an average major axis
particle diameter of 0.05 to 0.6 µm.

2. The positive presensitized lithographic printing plate of claim 1, wherein component (a-I) and/or component (a-II) are used in an amount of 3 to 90% by weight of a light-sensitive composition for forming the light-sensitive layer.

3. The positive presensitized lithographic printing plate of claim 1, wherein the alkali-soluble novolac resin is used in an amount of 3 to 90% by weight of a light-sensitive composition for forming the light-sensitive layer.

4. The positive presensitized lithographic printing plate of claim 1, wherein the weight ratio of component (a-I) and/or component (a-II) to the alkali-soluble novolak resin is 3:97 to 97:3.

5. The positive gresensitized lithographic printing plate of claim 1, wherein the positive-acting light-sensitive compound is used in an amount of 5 to 50% by weight of a light-sensitive composition for forming the light-sensitive layer.

6. The positive presensitized lithographic printing plate of claim 1, which further contains a compound which generates an acid upon photodegradation, combined with a compound having a -C-O-C or a -C-O-Si group that dissociates with an acid.

7. A process for producing the positive presensitized lithographic printing plate of claim 1, comprising roughening a surface of a continuously traveling support, continuously applying a light-sensitive solution onto said support and spraying high-pressure air to the as-applied and undried coating from a slit nozzle installed substantially perpendicular to the direction of travel, thereby drying said film continuously.

8. A process for producing the positive presensitized lithographic printing plate of claim 1, comprising roughening a surface of a continuously traveling support, continuously applying a light-sensitive solution onto said support and spraying high-pressure air to the as-applied and undried coating from a slit nozzle installed substantially perpendicular to the direction of travel while heating an underside of the support with a heating roller, thereby drying said film continuously.

## Patentansprüche

1. Positiv arbeitende vorsensibilisierte lithographische Druckplatte, umfassend einen Träger und eine lichtempfindliche Schicht, geformt darauf, wobei besagte lichtempfindliche Schicht enthält:
(a-I) eine Acrylverbindung mit hohem Molekulargewicht, welche unlöslich in Wasser aber löslich in einer alkalischen wässrigen Lösung ist, und welche ein Copolymer ist mit Struktureinheiten abgeleitet von mindestens einem der Monomeren (1) bis (4):
(1) Acrylamide, Methacrylamide, Acrylatester und Methacrylatester, jeweils mit aromatischen Hydroxylgruppen, und Hydroxystyrole, wie N-(4-Hydroxyphenyl)acrylamid, N-(4-Hydroxyphenyl)methacrylamid, o-, m- und p-Hydroxyphenylacrylate oder -methacrylate und o-, m- und p-Hydroxystyrole;
(2) Ungesättigte Carboxylsäuren, wie Acrylsäure, Methacrylsäure, Maleinsäureanhydrid und Itaconsäure;
(3) Verbindungen mit geringem Molekulargewicht mit jeweils, in einem Molekül, mindestens einer ungesättigten Bindung, polymerisierbar mit einer Sulfonamidogruppe mit mindestens einem Wasserstoffatom gebunden an ein Stickstoffatom, wie Verbindungen der folgenden Formeln (I) bis (V): 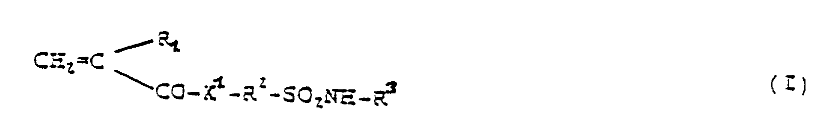 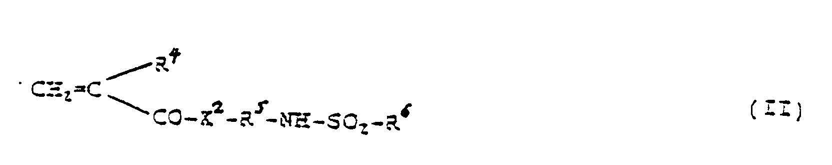 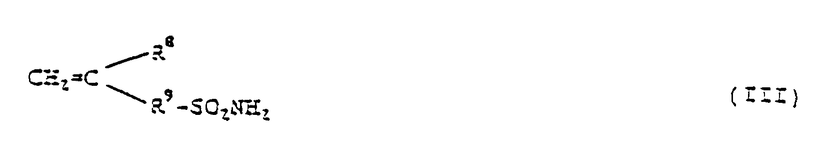 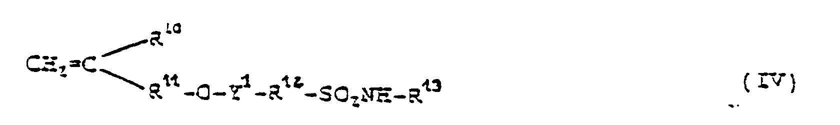 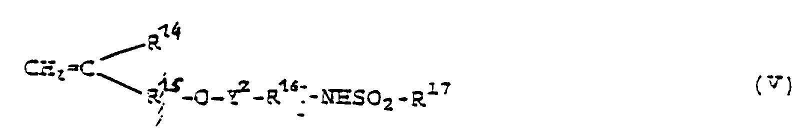 worin X¹ und X² jeweils -O- oder NR⁷- darstellen; R¹ und R⁴ jeweils ein Wasserstoffatom oder -CH₃ darstellen; R², R⁵, R⁹, R¹² und R¹⁶ jeweils ein optional substituiertes Alkylen mit 1 bis 12 Kohlenstoffatomen, Cycloalkylen, Arylen oderAralkylen darstellen; R³, R⁷ und R¹³ jeweils ein Wasserstoffatom oder ein optional substituiertes Alkyl mit 1 bis 12 Kohlenstoffatomen, Cycloalkyl, Aryl oder Aralkyl darstellen; R⁶ und R¹⁷ jeweils ein optional substituiertes Alkyl mit 1 bis 12 Kohlenstoffatomen, Cycloalkyl, Aryl oder Aralkyl darstellen; R⁸, R¹⁰ und R¹⁴ jeweils ein Wasserstoffatom, ein Halogenatom oder-CH₃ darstellen, R¹¹ und R¹⁵ jeweils eine Einfachbindung oder ein optional substituiertes Alkylen mit 1 bis 12 Kohlenstoffatomen, Cycloalkylen, Arylen oder Aralkylen darstellen; und Y¹ und Y² jeweils eine Einfachbindung oder -CO- darstellen, wobei spezifische Beispiele dieser Verbindungen m-Amino-sulfonylphenylmethacrylat, N-(p-Aminosulfonylphenyl)methacrylamid und N-(p-Aminosulfonylphenyl)acrylamid einschließen;
(4) Verbindungen mit geringem Molekulargewicht mit jeweils, in einem Molekül, mindestens einer ungesättigten Bindung, polymerisierbar mit einer aktiven Iminogruppe, wie dargestellt durch die folgende Formel (VI): 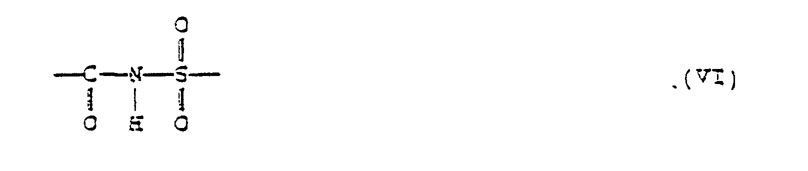 wobei Beispiele dieser Verbindungen N-(p-Toluolsulfonyl)methacrylimid und N-(p-Toluolsulfonyl)acrylimid einschließen;
und/oder
(a-II) eine Verbindung mit hohem Molekulargewicht auf Urethanbasis, welche unlöslich in Wasser aber löslich in einer alkalischen wässrigen Lösung ist,
(b) ein alkalilösliches Novolak-Harz, und
(c) eine positiv agierende lichtempfindliche Verbindung;
wobei entweder besagte Verbindung mit hohem Molekulargewicht oder besagtes Harz verteilte Inselphasen in einer Meerphase zur Verfügung stellen, wobei die Inseln sphärische oder ellipsoide Form haben, mit einem Maximum der Hauptachse des Partikeldurchmessers von 0,1 bis 0,8 µm und einem Mittelwert der Hauptachse des Partikeldurchmessers von 0,05 bis 0,6 µm.

2. Positiv arbeitende vorsensibilisierte lithographische Druckplatte nach Anspruch 1, wobei Komponente (a-I) und/oder Komponente (a-II) in einer Menge von 3 bis 90 Gew.-% einer lichtempfindlichen Zusammensetzung zur Formung der lichtempfindlichen Schicht verwendet werden.

3. Positiv arbeitende vorsensibilisierte lithographische Druckplatte nach Anspruch 1, wobei das alkalilösliche Novofak-Harz in einer Menge von 3 bis 90 Gew.-% einer lichtempfindlichen Zusammensetzung zur Formung der lichtempfindlichen Schicht verwendet wird.

4. Positiv arbeitende vorsensibilisierte lithographische Druckplatte nach Anspruch 1, wobei das Gewichtsverhältnis der Komponente (a-I) und/oder der Komponente (a-II) zum alkalilöslichen Novolak-Harz 3:97 bis 97:3 ist.

5. Positiv arbeitende vorsensibilisierte lithographische Druckplatte nach Anspruch 1, wobei die positiv agierende lichtempfindliche Verbindung in einer Menge von 5 bis 50 Gew.-% einer lichtempfindlichen Zusammensetzung zur Formung der lichtempfindlichen Schicht verwendet wird.

6. Positiv arbeitende vorsensibilisierte lithographische Druckplatte nach Anspruch 1, weiter enthaltend eine Verbindung, die eine Säure bei Fotodegradation erzeugt, kombiniert mit einer Verbindung mit einer -C-O-C- oder einer -C-O-Si-Gruppe, die mit einer Säure dissoziiert.

7. Verfahren zur Herstellung der positiv arbeitenden vorsensibilisierten lithographischen Druckplatte nach Anspruch 1, umfassend Aufrauen einer Oberfläche eines kontinuierlich vorwärts bewegten Trägers, kontinuierliche Auftragung einer lichtempfindlichen Lösung auf besagten Träger und Sprühen von Hochdruckluft auf die so aufgetragene und ungetrocknete Beschichtung, aus einer Schlitzdüse, installiert im Wesentlichen senkrecht zur Fortbewegungsrichtung, wodurch die Trocknung besagten Films kontinuierlich durchgeführt wird.

8. Verfahren zur Herstellung der positiv arbeitenden vorsensibilisierten lithographischen Druckplatte nach Anspruch 1, umfassend Aufrauen einer Oberfläche eines kontinuierlich vorwärts bewegten Trägers, kontinuierliche Auftragung einer lichtempfindlichen Lösung auf besagten Träger und Sprühen von Hochdruckluft auf die so aufgetragene und ungetrocknete Beschichtung, aus einer Schlitzdüse, installiert im Wesentlichen senkrecht zur Fortbewegungsrichtung, wobei eine Unterseite des Trägers mit einer Wärmewalze erwärmt wird, wodurch das Trocknen besagten Filmes kontinuierlich durchgeführt wird.

## Revendications

1. Plaque d'impression lithographique présensibilisée positive comprenant un support et une couche sensible à la lumière formée sur celui-ci, ladite couche photosensible contenant
(a-I) un composé acrylique de haute masse moléculaire qui est insoluble dans l'eau mais soluble dans une solution aqueuse alcaline, et qui est un copolymère ayant des unités structurales dérivées d'au moins l'un des monomères (1) à (4) :
(1) acrylamides, méthacrylamides, esters acrylates et esters méthacrylates, ayant chacun des groupes hydroxyle aromatiques, et hydroxystyrènes, comme le N-(4-hydroxyphényl)acrylamide, le N-(4-hydroxyphényl)méthacrylamide, les acrylates ou méthacrylates de o-, m- et p- hydroxyphényle, et les o-, m- et p-hydroxystyrènes ;
(2) acides carboxyliques insaturés comme l'acide acrylique, l'acide méthacrylique, l'anhydride maléique et l'acide itaconique ;
(3) composés de faible masse moléculaire ayant chacun, dans une molécule, au moins une liaison insaturée polymérisable avec un groupe sulfonamido ayant au moins un atome d'hydrogène lié à un atome d'azote, comme les composés des formules (I) à (V) suivantes : 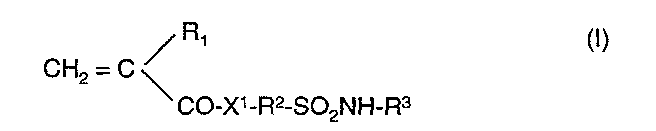 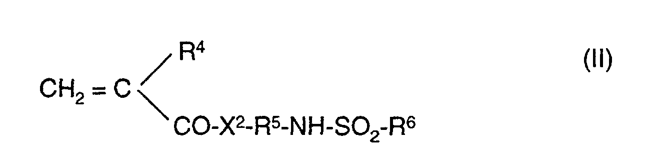 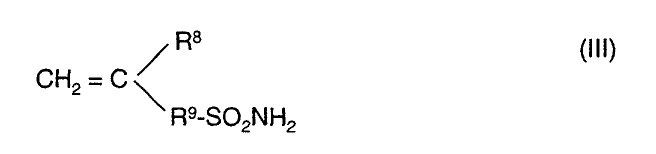 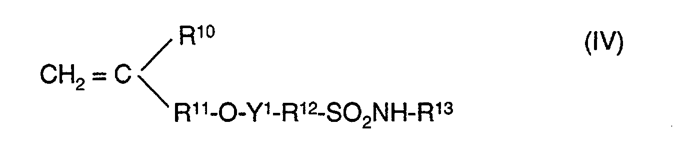 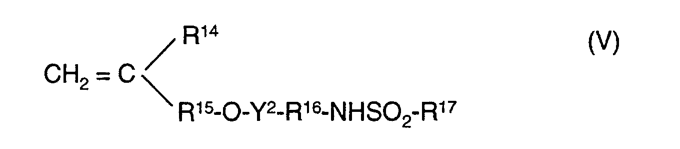 où X¹ et X² représentent chacun -O- ou NR⁷- ; R¹ et R⁴ représentent chacun un atome d'hydrogène ou -CH₃ ; R², R⁵, R⁹, R¹² et R¹⁶ représentent chacun un groupe alkylène éventuellement substitué ayant 1 à 12 atomes de carbone, cycloalkylène, arylène ou aralkylène ; R³, R⁷ et R¹³ représentent chacun un atome d'hydrogène ou un groupe alkyle éventuellement substitué ayant 1 à 12 atomes de carbone, cycloalkyle, aryle ou aralkyle ; R⁶ et R¹⁷ représentent chacun un groupe alkyle éventuellement substitué ayant 1 à 12 atomes de carbone, cycloalkyle, aryle ou aralkyle ; R⁸, R¹⁰ et R¹⁴ représentent chacun un atome d'hydrogène, un atome d'halogène ou -CH₃ ; R¹¹ et R¹⁵ représentent chacun une simple liaison ou un groupe alkylène éventuellement substitué ayant 1 à 12 atomes de carbone, cycloalkylène, arylène ou aralkylène ; et Y¹ et Y² représentent chacun une simple liaison ou -CO-, des exemples spécifiques de ces composés incluant le méthacrylate de m-aminosulfonylphényle, le N-(p-aminosulfonylphényl)méthacrylamide et le N-(p-aminosulfonylphényl)acrylamide ;
(4) composés de faible masse moléculaire ayant chacun, dans une molécule, au moins une liaison insaturée polymérisable avec un groupe imino actif, représentés par la formule (VI) suivante : 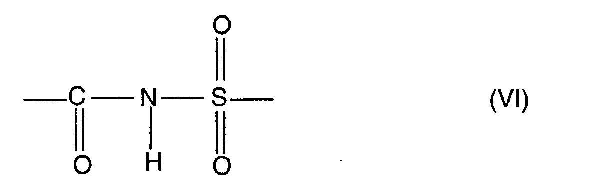 des exemples de ces composés incluant le N-(p-toluènesulfonyl)méthacrylimide et le N-(p-toluènesulfonyl)acrylimide,
et/ou
(a-II) un composé de haute masse moléculaire à base d'uréthane qui est insoluble dans l'eau mais soluble dans une solution aqueuse alcaline,
(b) une résine novolaque soluble dans les alcalis,
et
(c ) un composé sensible à la lumière à action positive ;
ledit composé de haute masse moléculaire ou ladite résine produisant des phases d'îles dispersées dans une phase de mer, les îles ayant une forme sphérique ou ellipsoïdale avec un diamètre de particule maximum suivant le grand axe de 0,1 à 0,8 µm et un diamètre de particule moyen suivant le grand axe de 0,05 à 0,6 µm.

2. Plaque d'impression lithographique présensibilisée positive selon la revendication 1 où le composant (a-I) et/ou le composant (a-II) sont utilisés en une quantité de 3 à 90% en masse d'une composition sensible à la lumière pour former la couche sensible à la lumière.

3. Plaque d'impression lithographique présensibilisée positive selon la revendication 1 où la résine novolaque soluble dans les alcalis est utilisée en une quantité de 3 à 90% en masse d'une composition sensible à la lumière pour former la couche sensible à la lumière.

4. Plaque d'impression lithographique présensibilisée positive selon la revendication 1 où le rapport massique du composant (a-I) et/ou du composant (a-II) à la résine novolaque soluble dans les alcalis est de 3:97 à 97:3.

5. Plaque d'impression lithographique présensibilisée positive selon la revendication 1 où le composé sensible à la lumière à action positive est utilisé en une quantité de 5 à 50% en masse d'une composition sensible à la lumière pour former la couche sensible à la lumière.

6. Plaque d'impression lithographique présensibilisée positive selon la revendication 1 qui contient en outre un composé qui produit un acide par photodégradation, combiné avec un composé ayant un groupe -C-O-C ou -C-O-Si qui se dissocie avec un acide.

7. Procédé pour produire la plaque d'impression lithographique présensibilisée positive selon la revendication 1 comprenant le dépolissage d'une surface d'un support qui se déplace en continu, l'application continue d'une solution sensible à la lumière sur ledit support et la projection d'air haute pression sur le revêtement tel qu'appliqué et non séché depuis une buse en forme de fente installée sensiblement perpendiculairement à la direction de déplacement, pour sécher ledit film en continu.

8. Procédé pour produire la plaque d'impression lithographique présensibilisée positive selon la revendication 1 comprenant le dépolissage d'une surface d'un support qui se déplace en continu, l'application continue d'une solution sensible à la lumière sur ledit support et la projection d'air haute pression sur le revêtement tel qu'appliqué et non séché depuis une buse en forme de fente installée sensiblement perpendiculairement à la direction de déplacement, tout en chauffant un côté inférieur du support avec un cylindre chauffant, pour sécher ledit film en continu.
